# EUROPÄISCHE PATENTSCHRIFT

(11) **EP 1 287 720 B1**
(45) Veröffentlichungstag und Bekanntmachung des Hinweises auf die Patenterteilung: **30.06.2004**
(21) Anmeldenummer: 01943375.4
(22) Anmeldetag: 16.05.2001
(51) Int. Cl.: H04R 17/00

(54) **ELEKTROMECHANISCHER WANDLER**
ELECTROMECHANICAL TRANSDUCER
TRANSDUCTEUR ELECTROMECANIQUE

(30) Priorität: 07.06.2000 DE 10028319
(43) Veröffentlichungstag der Anmeldung: 05.03.2003
(73) Patentinhaber: Endress + Hauser GmbH + Co.KG., 79689 Maulburg (DE)
(72) Erfinder: BIRGEL, Dietmar, 79650 Schopfheim (DE)
(74) Vertreter: Andres, Angelika
(86) Internationale Anmeldenummer: PCT/EP2001/005542
(87) Internationale Veröffentlichungsnummer: WO 2001/095667

(56) Entgegenhaltungen:
- EP-A- 0 875 741
- US-A- 4 488 080
- US-A- 4 701 659
- US-A- 5 092 243
- US-A- 5 773 913

## Beschreibung

Die Erfindung betrifft einen elektromechanischen Wandler mit in einem Stapel angeordneten piezoelektrischen Elementen, zwischen denen Kontaktelektroden angeordnet sind, über die die piezoelektrischen Elemente elektrisch angeschlossen sind.

Ein solchen elektromechanischer Wandler ist aus EP-A-0'875'721 bekannt.

Solche elektromechanischen Wandler werden z.B. in der Meßund Regeltechnik eingesetzt. So sind z.B. Vorrichtungen zur Feststellung und/oder Überwachung eines vorbestimmten Füllstandes in einem Behälter auf dem Markt, die ein auf der Höhe des vorbestimmten Füllstandes angebrachtes mechanisches Schwingungsgebilde aufweisen, das durch einen elektromechanischen Wandler zu Schwingungen anregt wird. Ein Beispiel für eine solche Vorrichtung ist in der DE-A 41 18 793 beschrieben. Die Schwingungen des mechanischen Schwingungsgebildes werden aufgenommen und in elektrische Signale umgewandelt, die einer weiteren Verarbeitung und/oder Auswertung zugänglich sind. Aus den elektrischen Signalen kann z.B. eine Frequenz und/oder eine Amplitude der Schwingung bestimmt werden. Frequenz und/oder Amplitude geben Aufschluß darüber, ob das mechanische Schwingungsgebilde von einem Füllgut bedeckt ist oder nicht.

Derartige Füllstandsgrenzschalter werden in vielen Industriezweigen, insb. in der Chemie und in der Lebensmittelindustrie eingesetzt. Sie dienen zur Grenzstandsdetektion und werden z.B. als Überfüllsicherung oder als Pumpenleerlaufschutz verwendet.

Elektromechanische Wandler mit in einem Stapel angeordneten piezoelektrischen Elementen bieten den Vorteil, daß mehrere piezoelektrische Elemente elektrisch parallel und mechanisch in Reihe geschaltet werden können. Hierdurch kann ein sehr robuster leistungsstarker Wandler erzielt werden.

Bei herkömmlichen elektromechanischen Wandlern werden die piezoelektrischen Elemente üblicherweise manuell aufgestapelt und es werden zwischen jeweils zwei benachbarten Elementen flächige Elektroden eingefügt und z.B. mittels eines Klebers befestigt. Diese Elektroden weisen aus dem Stapel heraus geführte Kontaktfahnen auf, über die die piezoelektrischen Elemente anzuschließen sind.

Die Herstellung eines solchen Stapels ist sehr arbeitsaufwendig. Dies ist, besonders bei den üblicherweise erforderlichen hohen Stückzahlen sehr kostenintensiv.

Es ist eine Aufgabe der Erfindung, einen elektromechanischen Wandler anzugeben, der einfach und kostengünstig herstellbar ist.

Hierzu besteht die Erfindung in einem elektromechanischen Wandler, welcher umfaßt:
- in einem Stapel angeordnete piezoelektrische Elemente,
   -- zwischen denen Kontaktelektroden angeordnet sind, über die die piezoelektrischen Elemente elektrisch angeschlossen sind,
- wobei die Kontaktelektroden aus einer flexiblen Leiterplatte heraus geführte flächige Anschlußfahnen sind.

Gemäß einer ersten Ausgestaltung weist die flexible Leiterplatte einen stufenförmig ausgebildeten Abschnitt auf, an jeder Stufe ist eine flächige Anschlußfahne heraus geführt, und die Stufen weisen eine Höhe auf, die gleich der Dicke der an die jeweilige Stufen angrenzenden piezoelektrischen Elemente ist.

Gemäß einer zweiten Ausgestaltung besteht der Stapel aus mindestens zwei aufeinander angeordneten Teilstapeln, und die piezoelektrischen Elemente jeden Teilstapels sind mittels um eine dem Teilstapel zugeordnete Grundfläche der flexiblen Leiterplatte herum angeordneten aus der Leiterplatte heraus geführten Anschlußfahnen angeschlossen.

Gemäß einer dritten Ausgestaltung weist die flexible Leiterplatte einen Abschnitt auf, in dem mehrere Leiterbahnen übereinander verlaufen und bei dem jede Leiterbahn in einer senkrecht zur Leiterbahn verlaufenden Anschlußfahne endet, wobei die einzelnen Anschlußfahnen zueinander parallel angeordnet sind und zum Anschluß von an sie angrenzenden piezoelektrischen Elementen dienen.

Gemäß einer Ausgestaltung einer der vorgenannten Ausgestaltungen sind auf der flexiblen Leiterplatte elektronische Bauteile, insb. SMD-Bauteile, angeordnet.

Weiter besteht die Erfindung in einem Verfahren zur Herstellung eines der vorgenannten elektromechanischen Wandlern, bei dem die flexible Leiterplatte mit Bauteilen bestückt wird, die Anschlußfahnen durch Verformen der flexiblen Leiterplatte parallel zueinander und übereinander angeordnet werden, wodurch die piezoelektrischen Elemente aufeinander gestapelt werden, und der Stapel verpreßt wird.

Gemäß einer Ausgestaltung des Verfahrens sind die Bauteile piezoelektrische Elemente und SMD-Bauteile, und die Bestückung erfolgt automatisch.

Außerdem besteht die Erfindung in einer Vorrichtung zur Feststellung und/oder Überwachung eines vorbestimmten Füllstandes in einem Behälter, welche Vorrichtung umfaßt:
- ein auf der Höhe des vorbestimmten Füllstandes anzubringendes mechanisches Schwingungsgebilde,
- einem erfindungsgemäßen elektromechanischen Wandler,
   -- der im Betrieb dazu dient das mechanische Schwingungsgebilde in Schwingungen zu versetzten und dessen von einem momentanen Füllstand abhängige Schwingungen aufzunehmen und einer weiteren Verarbeitung und/oder Auswertung zugänglich zu machen.

Ein Vorteil der Erfindung besteht darin, daß die Anschlußfahnen Bestandteil der flexiblen Leiterplatte sind. Sie sind also keine einzelnen losen Bauteile, die zusätzliche Kosten verursachen, sondern lediglich speziell ausgeformte Abschnitte der ohnehin vorhandenen Leiterplatte.

Die Anschlußfahnen der flexiblen Leiterplatte eignen sich besonders gut für eine maschinelle Fertigung. So können z.B. alle Anschlußfahnen gleichzeitig maschinell mit Kleber versehen und anschließend maschinell mit den piezoelektrischen Elementen bestückt werden. In dem gleichen Bestückungsvorgang können weitere auf der flexiblen Leiterplatte vorzusehende elektronische Bauteile in einem Arbeitsgang montiert werden.
Damit ist die Fertigung der erfindungsgemäßen elektromagnetischen Wandler sehr schnell, quasi vollautomatisch und damit sehr kostengünstig möglich.

Die Erfindung und weitere Vorteile werden nun anhand der Figuren der Zeichnung, in denen drei Ausführungsbeispiele dargestellt sind, näher erläutert; gleiche Elemente sind in den Figuren mit gleichen Bezugszeichen versehen.
- Fig. 1 zeigt: einen erfindungsgemäßen elektromechanischen Wandler;
- Fig. 2 zeigt: eine Ansicht einer flexible Leiterplatte mit stufenförmig angeordneten Anschlußfahnen;
- Fig. 3 zeigt: eine Ansicht einer flexible Leiterplatte mit ringförmig um eine Grundfläche angeordneten Anschlußfahnen;
- Fig. 4 zeigt: eine Ansicht einer flexible Leiterplatte mit einem Abschnitt in dem mehrere Leiterbahnen übereinander verlaufen und bei dem jede Leiterbahn in einer senkrecht zur Leiterbahn verlaufenden Anschlußfahne endet;
- Fig. 5 zeigt: einen Schnitt durch die in Fig. 4 dargestellte Leiterplatte;
- Fig. 6 zeigt: einen Schnitt durch eine Vorrichtung zur Feststellung und/oder Überwachung eines vorbestimmten Füllstandes in einem Behälter mit einem erfindungsgemäßen elektromechanischen Wandler; und
- Fig. 7 zeigt: einen Schnitt durch die Vorrichtung von Fig. 6, wobei die Schnittebene gegnüber der in Fig. 6 dargestellten Schnittebene um 90° gedreht ist.

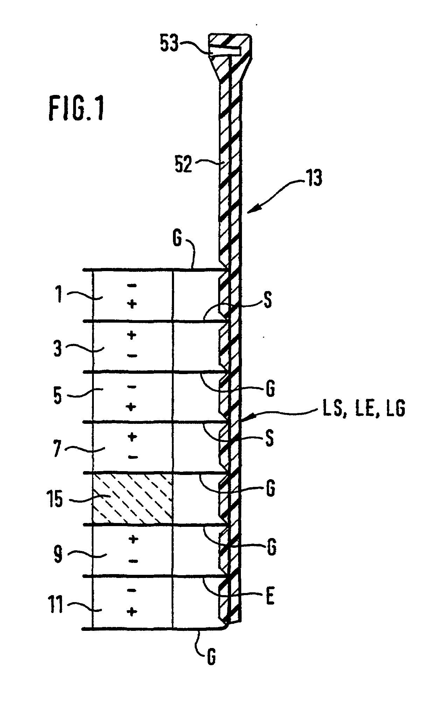

Fig. 1 zeigt einen erfindungsgemäß ausgebildeten elektromechanischer Wandler. Er umfaßt in einem Stapel angeordnete piezoelektrische Elemente 1, 3, 5, 7, 9, 11. Zwischen den piezoelektrischen Elementen 1, 3, 5, 7, 9, 11, oberhalb des zuoberst angeordneten piezoelektrischen Elements 1 und unterhalb des zuunterst angeordneten piezoelektrischen Elements 11 ist jeweils eine Kontaktelektrode S, E oder G angeordnet. Die piezoelektrischen Elemente 1, 3, 5, 7, 9, 11 sind über die Kontaktelektroden S, E, G elektrisch an in einer flexiblen Leiterplatte 13 verlaufende Leitungen, in dem gewählten Ausführungsbeispiel eine Sendesignalleitung LS, eine Empfangssignalleitung LE und eine Erdleitung LG, angeschlossen. Es sind in dem gewählten Ausführungsbeispiel die Kontaktelektroden S mit der Sendesignalleitung LS, die Kontaktelektroden E mit der Empfangssignalleitung LE und die Kontaktelektroden G mit der Erdleitung LG verbunden.

Die Reihenfolge der piezoelektrischen Elemente und deren elektrische Anschlußweise an Anschlußleitungen ist beliebig und ist in Abhängigkeit von der späteren Verwendung des Wandlers zu wählen.

Die in dem Ausführungsbeispiel gewählte Anordnung der piezoelektrischen Elemente 1, 3, 5, 7, 9, 11 und deren elektrische Beschaltung ist z.B. für eine Verwendung in einer eingangs beschriebenen Vorrichtung zur Feststellung und/oder Überwachung eines vorbestimmten Füllstandes geeignet.

Es sind die oberen vier piezoelektrischen Elemente 1, 3, 5, 7 elektrisch parallel und mechanisch in Reihe geschaltet. Hierzu ist die Kontaktelektrode G oberhalb des obersten piezoelektrischen Elements 1 mit der Erdleitung LG, die Kontaktelektrode S zwischen dem obersten piezoelektrischen Element 1 und dem dazu benachbarten piezoelektrischen Element 3 mit der Sendesignalleitung LS, die nächstfolgende Kontaktelektrode G zwischen dem piezoelektrischen Element 3 und dem piezoelektrischen Element 5 mit der Erdleitung LG, die Kontaktelektrode S zwischen dem piezoelektrischen Element 5 und dem piezoelektrischen Element 7 mit der Sendesignalleitung LS und die Kontaktelektrode G unterhalb des piezoelektrischen Elements 7 ist mit der Erdleitung LG verbunden. Die piezoelektrischen Elemente 1, 3, 5 und 7 weisen alle eine Polarisation parallel zu einer Längsachse des Stapels auf. Benachbarte piezoelektrische Elemente 1-3, 3-5, 5-7 sind jedoch entgegengesetzt polarisiert. Dies ist in Fig. 1 durch die Markierung mit + und - dargestellt.

Eine über die Sendesignalleitung LS zugeführte Wechselspannung führt zu einer synchronen gleich gerichteten Dickenoszillation der piezoelektrischen Elemente 1, 3, 5, 7. Der durch die piezoelektrischen Elemente 1, 3, 5, 7 gebildete Teilstapel dient z.B. als ein Sender zur Anregung von von der zugeführten Wechselspannung abhängigen Schwingungen.

Unterhalb des piezoelektrischen Elements 7 ist eine Trennscheibe 15 aus einem Isolator, z.B. aus einer Keramik, angeordnet. Die Trennscheibe 15 bewirkt eine elektrische und mechanische Entkopplung der oberen piezoelektrischen Elemente 1, 3, 5, 7 von den unterhalb der Trennscheibe 15 angeordneten piezoelektrischen Elemente 9, 11.

In dem gezeigten Ausführungsbeispiel ist der durch die piezoelektrischen Elemente 9, 11 gebildete Teilstapel als Empfänger ausgebildet. Es sind die piezoelektrischen Elemente 9, 11 elektrisch parallel und mechanisch in Reihe geschaltet. Hierzu ist Kontaktelektrode G oberhalb des piezoelektrischen Elements 9 und die Kontaktelektrode G unterhalb des piezoelektrischen Elements 11 mit der Erdleitung LG verbunden. Die zwischen den piezoelektrischen Elementen 9 und 11 angeordnete Kontaktelektrode E ist mit der Empfangssignalleitung LE verbunden.

Wird ein mechanisches Schwingungsgebilde durch den Sender zu Schwingungen angeregt, so führen der Stapel und das Schwingungsgebilde Schwingungen aus, die über den Empfänger in Form einer über die Empfangssignalleitung LE abnehmbaren sich abhängig von der resultierenden Schwingung ändernden Spannung einer weiteren Verarbeitung und/oder Auswertung zugänglich ist.

Flexible Leiterplatten werden z.B. von der Firma Schoeller Elektronik unter dem Handelsnamen Polyflex vertrieben. Sie bestehen z.B. aus einem dünnen Kupferblech, das von der Firma Schoeller Elektronik entsprechend einer gewünschten Leiterbahnkonfiguration in einem Ätzprozeß behandelt und auf das nachfolgend beidseitig jeweils eine dicke Polyimid-Deckfolie auflaminiert wird.

Erfindungsgemäß wird eine flexible Leiterplatte 13 verwendet, bei der die Kontaktelektroden S, E, G aus der flexiblen Leiterplatte 13 heraus geführte flächige Anschlußfahnen sind. Die Anschlußfahnen sind integraler Bestandteil der flexiblen Leiterplatte 13. Sie werden z.B. aus entsprechend geformten Segmenten des Kupferblechs gebildet, die nicht mit einer Deckfolie versehen sind.

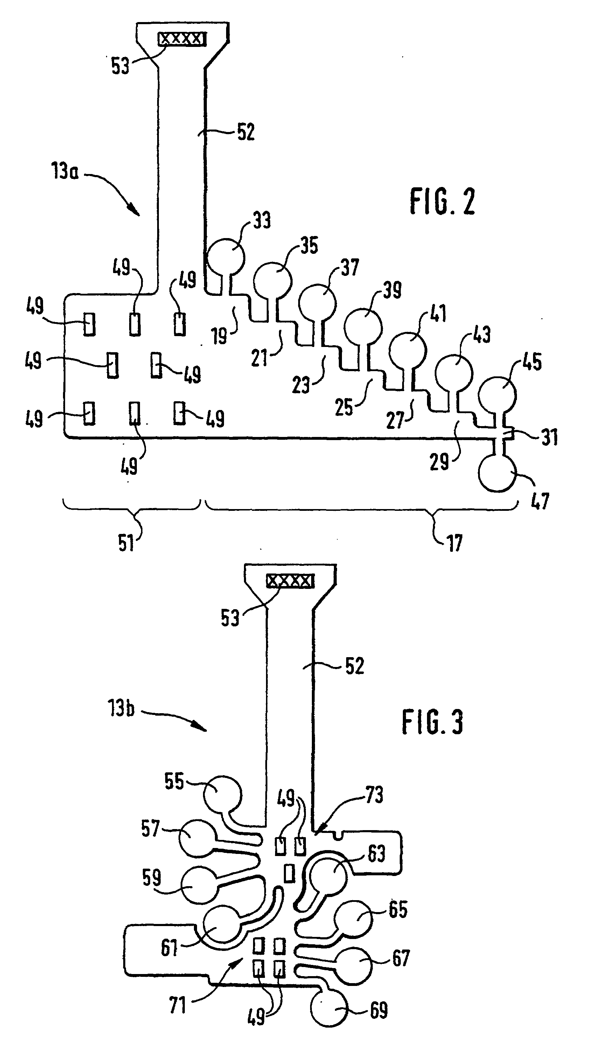

Fig. 2 zeigt eine Ansicht eines ersten Ausführungsbeispiels einer erfindungsgemäß ausgebildeten flexible Leiterplatte 13a. Sie weist einen stufenförmig ausgebildeten Abschnitt 17 auf. Er umfaßt in dem gezeigten Ausführungsbeispiel sieben Stufen 19, 21, 23, 25, 27, 29, 31. An jeder Stufe 19, 21, 23, 25, 27, 29, 31 ist eine flächige Anschlußfahne 33, 35, 37, 39, 41, 43, 45 heraus geführt. Die am Rand den Abschnitt 17 abschließende Stufe 31 ist sehr niedrig. An dieser Stufe 31 in nicht nur an einer Oberseite der Stufe 31 die Anschlußfahne 45 heraus geführt, sondern es ist zusätzlich aus einer Unterseite der Stufe 31 eine weitere Anschlußfahne 47 heraus geführt. Die Anschlußfahnen 33, 35, 37, 39, 41, 43, 45, 47 weisen jeweils einen schmalen Steg und eine an dessen stufen-abgewandten Ende angeformte kreisscheibenförmige Elektrodenfläche auf.

Die Stufen 33, 35, 37, 39, 41, 43, 45 weisen eine Höhe auf, die gleich der Dicke der an die jeweilige Stufen 33, 35, 37, 39, 41, 43, 45 angrenzenden piezoelektrischen Elemente 1, 3, 5, 7, 9, 11 ist.

Bei der Herstellung eines erfindungsgemäßen elektromechanischen Wandlers wird zunächst die flexible Leiterplatte 13a mit Bauteilen bestückt. Mit Bauteilen sind hier die piezoelektrischen Elemente 1, 3, 5, 7, 9, 11, die Trennscheibe 15 und gegebenenfalls auch andere auf der Leiterplatte 13a benötigte elektrische Bauelemente gemeint. Vorzugsweise sind die elektrischen Bauelemente in Fig. 2 lediglich schematisch dargestellte oberflächen-montierbare Bausteine, sogenannte SMD-Bauteile 49, so daß die Bestückung der Leiterplatte 13a voll automatisch erfolgen kann. Die SMD-Bauteile 49 sind auf einem an den stufenförmigen Abschnitt 17 angrenzenden Abschnitt 51 angeordnet.

Bei der Montage der piezoelektrischen Elemente 1, 3, 5, 7, 9, 11 wird auf die Anschlußfahnen 33, 35, 37, 39, 41, 43, 45, 47 ein Kleber, z.B. ein Leitkleber oder ein SMD-Kleber, aufgebracht und es wird das piezoelektrische Element 1 auf die Anschlußfahne 33, das piezoelektrische Element 3 auf die Anschlußfahne 35, das piezoelektrische Element 5 auf die Anschlußfahne 37, das piezoelektrische Element 7 auf die Anschlußfahne 39, die Trennscheibe 15 auf die Anschlußfahne 41, das piezoelektrische Element 9 auf die Anschlußfahne 43 und das piezoelektrische Element 11 auf die Anschlußfahne 45 aufgebracht.

Nachfolgend werden die Anschlußfahnen 33, 35, 37, 39, 41, 43, 45, 47 durch Verformen der flexiblen Leiterplatte 13a parallel zueinander und übereinander angeordnet. Bei dem in Fig. 2 dargestellten Ausführungsbeispiel erfolgt dies, indem alle Anschlußfahnen 33, 35, 37, 39, 41, 43, 45, 47 aufgestellt werden, bis sie senkrecht zum Abschnitt 17 der Leiterplatte 13a verlaufen, und der Abschnitt 17 beginnend von der Seite der niedrigsten Stufe 31 her aufgerollt wird. Dadurch werden die piezoelektrischen Elemente 1, 3, 5 ,7, 9, 11 unter Zwischenfügung der Trennscheibe 15 aufeinander gestapelt. Der so vorgeformte Stapel wird anschließend verpreßt, um eine sichere elektrische Verbindung zwischen den Anschlußfahnen 33, 35, 37, 39, 41, 43, 45, 47 und den piezoelektrischen Elementen 1, 3, 5, 7, 9, 11 zu gewährleisten.

In Übereinstimmung mit dem in Fig. 1 dargestellten elektromechanischen Wandler 13, bilden die Anschlußfahnen 33, 37, 41, 43 und 47 Kontaktelektroden G die mit einer in der Leiterplatte 13a verlaufenden, in Fig. 2 nicht dargestellten Erdleitung LG verbunden sind. Die Anschlußfahnen 35, 39 bilden Kontaktelektroden S, die mit einen in der Leiterplatte 13a verlaufenden, in Fig. 2 nicht dargestellten Sendesignalleitung LS verbunden sind. Die Anschlußfahne 45 bildet eine Kontaktelektrode E, die mit einer in der Leiterplatte 13a verlaufenden, in Fig. 2 nicht dargestellten Empfangssignalleitung LE verbunden ist.

Die Leiterplatte 13a weist einen schmalen senkrecht zu den Abschnitten 17 und 51 sich erstreckenden Fortsatz 52 auf, an dessen Ende ein Stecker 53 vorgesehen ist. In dem Fortsatz 52 sind sämtliche Leitungen der Leiterplatte 13a fortgeführt, die mit einem Anschluß außerhalb der Leiterplatte 13a zu verbinden sind. Hierzu gehören in dem gewählten Ausführungsbeispiel die Sendesignalleitung LS, die Empfangssignalleitung LE und die Erdleitung LG.

Fig. 3 zeigt eine Ansicht eines weiteren Ausführungsbeispiels einer flexible Leiterplatte 13b. Die Leiterplatte 13b unterscheidet sich von der in Fig. 2 dargestellten Leiterplatte 13a lediglich durch die Anordnung der Anschlußfahnen und die Position der SMD-Bauteile 49 auf der Leiterplatte 13a bzw. 13b.

Bei dem in Fig. 3 dargestellten Ausführungsbeispiel sind Anschlußfahnen 55, 57, 59, 61, 63, 65, 67, 69 vorgesehen, die jeweils ringförmig um eine Grundfläche 71, 73 angeordnet.

Auch bei diesem Ausführungsbeispiel ist vorgesehen, daß der Stapel, wie in Fig. 1 dargestellt, aufgebaut ist und aus mindestens zwei aufeinander angeordneten Teilstapeln besteht. Entsprechend sind die Anschlußfahnen 55, 57, 59, 61 um die Grundfläche 71 herum angeordnet und die Anschlußfahnen 63, 65, 67, 69 sind um die Grundfläche 73 herum angeordnet.

Die piezoelektrischen Elemente 1, 3, 5, 7, 9, 11 jeden Teilstapels 1-3-5-7 bzw. 9-11 sind mittels um die dem Teilstapel zugeordnete Grundfläche 71, 73 der flexiblen Leiterplatte 13b herum angeordnete aus der Leiterplatte 13b heraus geführte Anschlußfahnen 55, 57, 59, 61, 63, 65, 67, 69 angeschlossen.

Bei der Montage der piezoelektrischen Elemente 1, 3, 5, 7, 9, 11 wird auf die Anschlußfahnen 55, 57, 59, 61, 63, 65, 67, 69 ein Kleber, z.B. ein Leitkleber oder ein SMD-Kleber, aufgebracht und es wird das piezoelektrische Element 1 auf die Anschlußfahne 55, das piezoelektrische Element 3 auf die Anschlußfahne 57, das piezoelektrische Element 5 auf die Anschlußfahne 59, das piezoelektrische Element 7 auf die Anschlußfahne 61, die Trennscheibe 15 auf die Anschlußfahne 63, das piezoelektrische Element 9 auf die Anschlußfahne 65 und das piezoelektrische Element 11 auf die Anschlußfahne 67 aufgebracht.

Nachfolgend werden die Anschlußfahnen 55, 57, 59, 61, 63, 65, 67, 69 durch Verformen der flexiblen Leiterplatte 13b parallel zueinander und übereinander angeordnet. Bei dem in Fig. 3 dargestellten Ausführungsbeispiel erfolgt dies, indem die Anschlußfahne 69 aufgebogen wird, bis sie senkrecht zur Leiterplatte 13b verläuft. Anschließend wird die Anschlußfahne 67 umgefaltet, derart, daß das darauf montierte piezoelektrische Element 11 flächig auf der Anschlußfahne 69 aufliegt. Entsprechend wird mit den nachfolgenden Anschlußfahne 65, 63, 61, 59, 57, 55 verfahren. Es liegt schlußendlich das auf der Anschlußfahne 65 angeordnete piezoelektrische Element 9 auf einer dem piezoelektrischen Element 11 abgewandten Oberfläche der Anschlußfahne 67, die auf der Anschlußfahne 63 angeordnete Trennscheibe 15 auf einer dem piezoelektrischen Element 9 abgewandten Oberfläche der Anschlußfahne 65, das auf der Anschlußfahne 61 angeordnete piezoelektrische Element 7 auf einer der Trennscheibe 15 abgewandten Oberfläche der Anschlußfahne 63, das auf der Anschlußfahne 59 angeordnete piezoelektrische Element 5 auf einer dem piezoelektrischen Element 7 abgewandten Oberfläche der Anschlußfahne 61, das auf der Anschlußfahne 57 angeordnete piezoelektrische Element 3 auf einer dem piezoelektrischen Element 5 abgewandten Oberfläche der Anschlußfahne 59 und das auf der Anschlußfahne 55 angeordnete piezoelektrische Element 1 auf einer dem piezoelektrischen Element 3 abgewandten Oberfläche der Anschlußfahne 57 auf.

Auch hier wird also die flexible Leiterplatte 13b mit Bauteilen bestückt, es werden die Anschlußfahnen 55, 57, 59, 61, 63, 65, 67, 69 durch Verformen der flexiblen Leiterplatte 13b parallel zueinander und übereinander angeordnet werden, wodurch die piezoelektrischen Elemente 1, 3, 5, 7, 9, 11 aufeinander gestapelt werden, und anschießende wird der Stapel verpreßt.

Die Grundflächen 71, 73 liegen in diesem Zustand nahezu als Tangentialflächen außen an den beiden Teilstapeln an. Auf den beiden Grundflächen 71, 73 sind SMD-Bauteile 49 angeordnet. Selbstverständlich können diese oder auch andere elektronische Bauteile auch an anderen Orten der Leiterplatte 13b vorgesehen sein.

In Übereinstimmung mit dem in Fig. 1 dargestellten elektromechanischen Wandler 13, bilden die Anschlußfahnen 55, 59, 63, 65, 69 hier entsprechend Kontaktelektroden G die mit einer in der Leiterplatte 13b verlaufenden, in Fig. 3 nicht dargestellten Erdleitung LG verbunden sind. Die Anschlußfahnen 57, 61 bilden Kontaktelektroden S, die mit einen in der Leiterplatte 13b verlaufenden, in Fig. 3 nicht dargestellten Sendesignalleitung LS verbunden sind. Die Anschlußfahne 67 bildet eine Kontaktelektrode E, die mit einer in der Leiterplatte 13b verlaufenden, in Fig. 3 nicht dargestellten, Empfangssignalleitung LE verbunden ist.

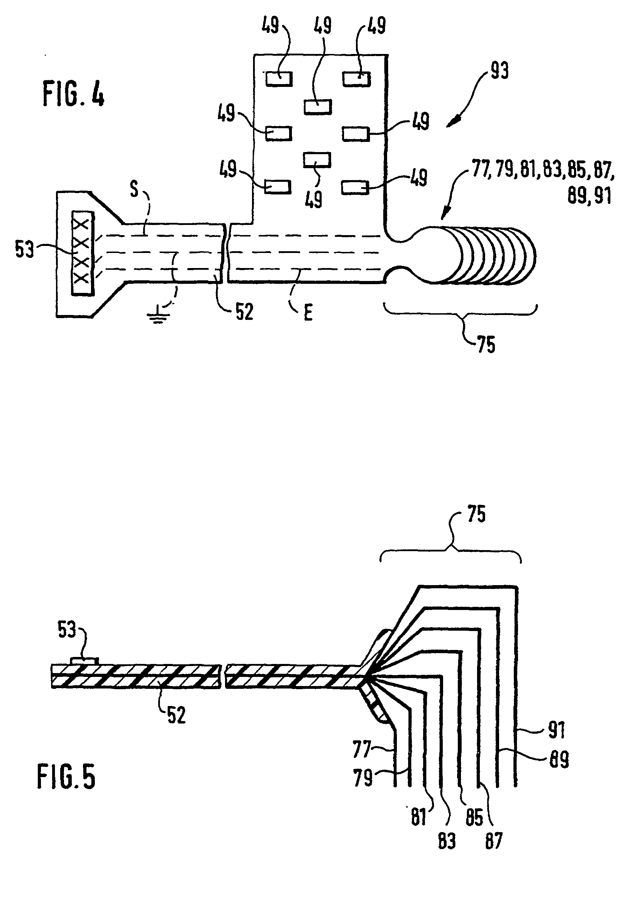

In den Figuren 4 und 5 ist ein weiteres Ausführungsbeispiel einer flexiblen Leiterplatte 13c dargestellt. Es werden nachfolgend lediglich die Unterschiede zu den vorangehenden Ausführungsbeispielen näher erläutert.

Die flexible Leiterplatte 13c weist einen Abschnitt 75 auf, in dem mehrere Leiterbahnen übereinander verlaufen. Jede der Leiterbahnen endet in einer senkrecht zur Leiterbahn verlaufenden Anschlußfahne 77, 79, 81, 83, 85, 87, 89, 91. Die einzelnen Anschlußfahnen 77, 79, 81, 83, 85, 87, 89, 91 sind zueinander parallel angeordnet und dienen zum Anschluß von an sie angrenzende piezoelektrische Elementen 1, 3, 5, 7, 9.

Bei der Herstellung werden die Anschlußfahnen 77, 79, 81, 83, 85, 87, 89, 91 hierzu mit einem Kleber versehen und es werden die Zwischenräume zwischen den Anschlußfahnen 77, 79, 81, 83, 85, 87, 89, 91 mit den piezoelektrischen Elementen 1, 3, 5, 7, 9, 11 und der Trennscheibe 15 bestückt. Dabei wird das piezoelektrische Element 1 zwischen die Anschlußfahnen 77 und 79, das piezoelektrische Element 3 zwischen die Anschlußfahnen 79 und 81, das piezoelektrische Element 5 zwischen die Anschlußfahnen 81 und 83, das piezoelektrische Element 7 zwischen die Anschlußfahnen 83 und 85, die Trennscheibe 15 zwischen die Anschlußfahnen 85 und 87, das piezoelektrische Element 9 zwischen die Anschlußfahnen 87 und 89 und das piezoelektrische Element 11 zwischen die Anschlußfahnen 89 und 91 gesetzt.

Bei diesem Ausführungsbeispiel ist eine besondere Verformung der flexiblen Leiterplatte 13c nicht erfoderlich, da die Anschlußfahnen 77, 79, 81, 83, 85, 87, 89, 91 bereits im wesentlichen deren endgültige Position aufweisen, d.h. in der gezeigten Form sind sie bereits aufgestellt, so daß sie senkrecht zur Leiterplattenebene verlaufen. Nach der Bestückung ist es auch hier notwendig, den Stapel zu verpressen, um eine dauerhafte elektrische und mechanische Verbindung mit den Anschlußfahnen 77, 79, 81, 83, 85, 87, 89, 91 herzustellen.

Der elektrische Anschluß der Anschlußfahnen 77, 79, 81, 83, 85, 87, 89, 91 an die Sendesignalleitung LS, die Empfangssignalleitung LE und die Erdleitung LG erfolgt analog zu den beiden vorangegangen Ausführungsbeispielen und ist daher hier nicht erneut aufgeführt.

Genau wie bei den vorangehenden Ausführungsbeispiele weist die flexible Leiterplatte 13c einen länglichen Fortsatz 52 auf, an dessen Ende ein Stecker 53 vorgesehen ist, über den in der Leiterplatte 13c verlaufende Leitungsbahnen von außen kontaktierbar sind. Im rechten Winkel zu dem Fortsatz 52 ist ein weiterer Abschnitt 93 der Leiterplatte 13c vorgesehen, auf dem elektronische Bauteile angeordnet sein können. Dies sind vorzugsweise, wie in Fig. 5 schematisch angedeutet, SMD-Bauteil 49, die zusammen mit den piezoelektrischen Elementen 1, 3, 5, 7, 9,11 und der Trennscheibe 15 in einem automatischen Bestückungsvorgang aufgebracht werden können.

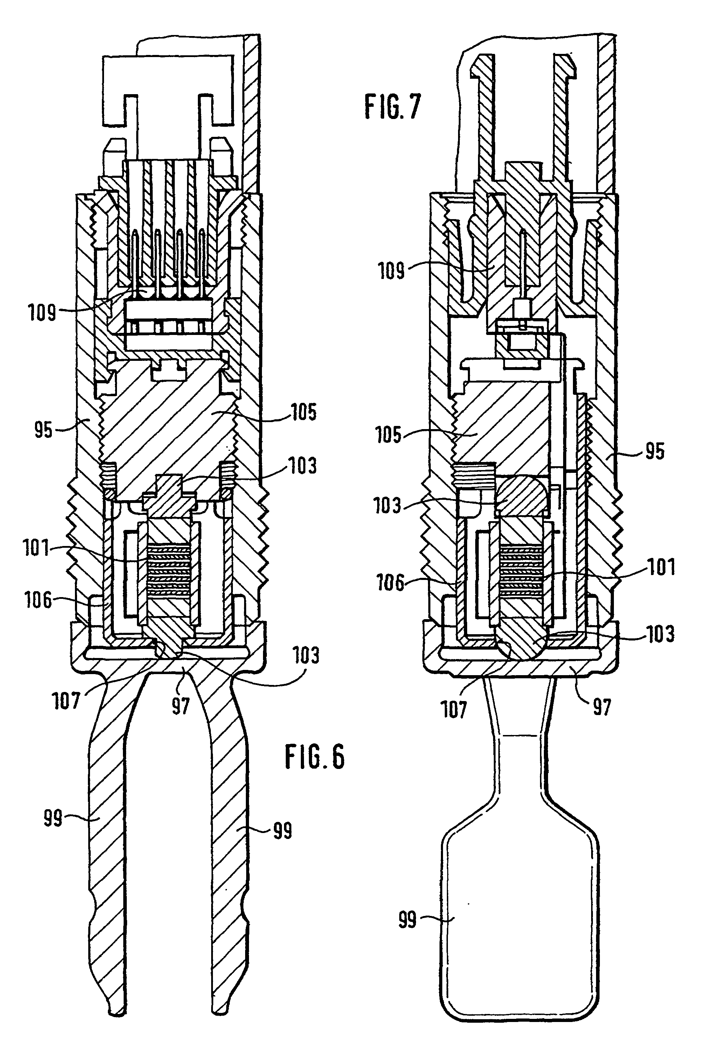

Fig. 6 und 7 zeigen zwei um 90° gegeneinander gedrehte Schnittebenen durch eine Vorrichtung zur Feststellung und/oder Überwachung eines vorbestimmten Füllstandes in einem Behälter, die einen erfindungsgemäßen elektromechanischen Wandler 101 aufweist.

Die Vorrichtung weist ein im wesentlichen zylindrisches Gehäuse 95 auf, das endseitig von einer kreisscheibenförmigen Membran 97 frontbündig verschlossen ist. An der Außenseite des Gehäuses 95 sind an der Membran 97 zwei in den Behälter weisende Schwingstäbe 99 angeformt. Gehäuse 95, Membran 97 und Schwingstäbe 99 sind Bestandteile eines mechanischen Schwingungsgebildes, das durch einen im Inneren des Gehäuses 95 angeordneten elektromechanischen Wandler 101 in Schwingungen versetzt wird. Dabei führt die Membran 97 Biegeschwingungen aus und die Schwingstäbe 99 werden in Schwingungen senkrecht zu deren Längsachse versetzt. Es sind jedoch auch Schwingungsgebilde einsetzbar, die nur einen oder keine Schwingstäbe aufweisen. Bei den letztgenannten kommt z.B. nur die schwingende Membran mit einem in dem Behälter befindlichen Füllgut in Kontakt.

Die Vorrichtung ist auf der Höhe eines vorbestimmten Füllstandes anzubringen. Hierzu ist am Gehäuse 95 ein Außengewinde vorgesehen, mittels dessen die Vorrichtung in eine entsprechende Öffnung in einem Behälter einschraubbar ist. Andere Arten der Befestigung, z.B. mittels Flanschen, sind ebenfalls einsetzbar. Andere Arten der Befestigung, z.B. mittels Flanschen, sind ebenfalls einsetzbar.

Es ist ein erfindungsgemäßer elektromechanischer Wandler 101 vorgesehen, wie er zuvor anhand der in den Figuren 1 bis 5 dargestellten Ausführungsbeispiele beschrieben wurde. Er dient im Betrieb dazu das mechanische Schwingungsgebilde in Schwingungen zu versetzten und dessen von einem momentanen Füllstand abhängige Schwingungen aufzunehmen und einer weiteren Verarbeitung und/oder Auswertung zugänglich zu machen.

Der Wandler 101 ist zwischen einem ersten und einem zweiten jeweils endseitig an den Stapel angrenzenden Stempel 103 eingefaßt. Die Stempel 103 bestehen vorzugsweise aus einem sehr harten Material, z.B. einem Metall.

Der Wandler 101 ist entlang einer Längsachse des Gehäuses 95 zwischen einer in das Gehäuses 95 eingeschraubten Druckschraube 105 und der Membran 97 eingespannt. Hierdurch ist die Membran 97 vorgespannt.

Der Sender dient dazu im Betrieb das mechanische Schwingungsgebilde zu mechanischen Schwingungen anzuregen. Hierzu liegt am Sender im Betrieb ein elektrisches Sendesignal an, durch das der Sender und damit der Wandler 101 zu Dickenoszillationen angeregt wird.

Entsprechend führt eine Schwingung der Schwingstäbe 99 zu einer Biegeschwingung der Membran 97, die wiederum eine Dickenoszillation des Wandlers 101 bewirkt. Diese Dickenoszillation führt zu einer Veränderung der über dem Empfänger abfallenden Spannung. Ein entsprechendes Empfangssignal steht über die Empfangssignalleitung LE zur Verfügung.

Die Amplitude dieser Empfangssignale ist um so größer, je größer die mechanische Schwingungsamplitude des mechanischen Schwingungsgebildes ist. In Ausnutzung dieser Tatsache wird die Anordnung vorzugsweise bei deren Resonanzfrequenz fᵣ betrieben. Bei der Resonanzfrequenz fᵣ ist die mechanische Schwingungsamplitude maximal.

Damit das mechanische Schwingungsgebilde in Schwingungen bei dessen Resonanzfrequenz fᵣ versetzt wird, kann z.B. ein Regelkreis vorgesehen sein, der eine zwischen dem Sendesignal und dem Empfangssignal bestehende Phasendifferenz auf einen bestimmten konstanten Wert regelt, z.B. indem ein Empfangssignal über einen Phasenschieber und einen Verstärker auf das Sendesignal zurück gekoppelt wird. Ein solcher Regelkreis ist z. B. in der DE-A 44 19 617 beschrieben.

Die sich einstellende Resonanzfrequenz fᵣ und deren Amplitude hängen davon ab, ob das mechanische Schwingungsgebilde von dem Füllgut im Behälter bedeckt ist oder nicht. Entsprechend können eine oder auch beide Meßgrößen zur Feststellung und/oder zur Überwachung des vorbestimmten Füllstandes herangezogen werden.

Es kann z.B. das Empfangssignal einer Auswerteeinheit zugeführt sein, die mittels einer Frequenzmeßschaltung dessen Frequenz bestimmt und das Ergebnis einem Komparator zuführt. Dieser vergleicht die gemessene Frequenz mit einer in einem Speicher abgelegten Referenzfrequenz f_{R}. Ist die gemessene Frequenz kleiner als die Referenzfrequenz f_{R} gibt die Auswerteeinheit ein Ausgangssignal ab, das angibt, daß das mechanische Schwingungsgebilde von einem Füllgut bedeckt ist. Weist die Frequenz einen Wert auf der größer als die Referenzfrequenz f_{R} ist, so gibt die Auswerteeinheit ein Ausgangssignal ab, das angibt, daß das mechanische Schwingungsgebilde nicht vom Füllgut bedeckt ist.

Das Ausgangssignal ist z.B. eine Spannung, die einen entsprechenden Wert annimmt oder ein Strom, der einen entsprechenden Wert aufweist oder dem ein Signalstrom in Form von Pulsen mit einer entsprechenden Frequenz oder einer entsprechenden Dauer überlagert ist.

Die piezoelektrischen Elemente 1, 3, 5, 7, 9, 11 sind in eine Hülse eingebracht aus der seitlich die flexible Leiterplatte 13 heraus geführt ist. Die Stempel 103 sind endseitig auf die Hülse aufgesteckt. Die Leiterplatte ist im montierten Zustand um den Stapel herum gewickelt und in einem Einsatz 106 in dem Gehäuse 95 angeordnet. Der Einsatz 106 ist im wesentlichen topfförmig und weist einen Boden auf, in dessen Mitte eine durchgehende Öffnung 107 vorgesehen ist. Die Form der Öffnung 107 ist der des Stempels 103 nachempfunden. Die Membran 97 weist vorzugsweise eine der Form des ersten Stempels 103 nachempfundene Mulde auf, in der die runde Kuppel des Stempels 103 drehbar gelagert ist. Diese Form der Lagerung bietet den Vorteil, daß aufgrund der runden Form der Kuppel und der Mulde eine Drehung ohne große Reibungsverluste und ohne auf den Stapel einwirkende Torsionskräfte ohne weiteres möglich ist und trotzdem gleichzeitig aufgrund der großen Auflagefläche der Kuppel in der Mulde eine sehr gute mechanische Kraftübertragung vom Stapel auf die Membran 97 gewährleistet ist.

Der Einsatz 106 weist einen in membran-abgewandter Richtung fortgeführten schmalen Wandabschnitt auf, der als Schutzlehne für den zum Stecker 53 führenden Abschnitt 52 der flexiblen Leiterplatte 13 dient.

Die Druckschraube 105 ist mit dem Einsatz 106 mittels einem Schnappverschluß verbunden. Hierzu weist der Einsatz 106 zwei einander gegenüberliegend an dessen membranabgewandten Ende angeordnete Ausnehmungen auf, in die entsprechend geformte an einem membran-zugewandten Ende der Druckschraube 105 vorgesehene Rastnasen einrasten. Der Schnappverschluß bietet den Vorteil, daß der Einsatz 106 und die Druckschraube 105 auf sehr einfache Weise fest mit einander verbunden sind.

Die Druckschraube 105 weist eine seitlich offene Ausnehmung auf, durch die der mit dem Stecker 53 verbundene Abschnitt 52 der flexiblen Leiterplatte 13 hindurch geführt ist.

Auf den Stecker ist ein Steckverbinder 109 aufgesetzt, über den der elektromechanische Wandler angeschließbar ist.

## Patentansprüche

1. Elektromechanischer Wandler, welcher umfaßt:
- in einem Stapel angeordnete piezoelektrische Elemente (1, 3, 5, 7, 9, 11),
- zwischen denen Kontaktelektroden (G, S, E) angeordnet sind, über die die piezoelektrischen Elemente (1, 3, 5, 7, 9, 11) elektrisch angeschlossen sind, **dadurch gekennzeichnet, dass**
- die Kontaktelektroden (G, S, E) aus einer flexiblen Leiterplatte (13, 13a, 13b, 13c) heraus geführte flächige Anschlußfahnen (33, 35, 37, 39, 41, 43, 45, 47, 55, 57, 59, 61, 63, 65, 67, 69, 77, 79, 81, 83, 85, 87, 89, 91) sind.

2. Elektromechanischer Wandler gemäß Anspruch 1, bei dem
- die flexible Leiterplatte (13a) einen stufenförmig ausgebildeten Abschnitt (17) aufweist,
- an jeder Stufe (19, 21, 23, 25, 27, 29, 31) eine flächige Anschlußfahne (33, 35, 37, 39, 41, 43, 45, 47, 49) heraus geführt ist, und
- die Stufen (19, 21, 23, 25, 27, 29, 31) eine Höhe aufweisen, die gleich der Dicke der an die jeweilige Stufe (19, 21, 23, 25, 27, 29, 31) angrenzenden piezoelektrischen Elemente (1, 3, 5, 7, 9, 11) ist.

3. Elektromechanischer Wandler gemäß Anspruch 1, bei dem
- der Stapel aus mindestens zwei aufeinander angeordneten Teilstapeln bestehen, und
- die piezoelektrischen Elemente (1, 3, 5, 7; 9, 11) jeden Teilstapels mittels um eine dem Teilstapel zugeordnete Grundfläche (71, 73) der flexiblen Leiterplatte (13b) herum angeordnete aus der Leiterplatte (13b) heraus geführte Anschlußfahnen (55, 57, 59, 61, 63, 65, 67, 69) angeschlossen sind.

4. Elektromechanischer Wandler gemäß Anspruch 1, bei dem die flexible Leiterplatte (13c) einen Abschnitt (75) aufweist, in dem mehrere Leiterbahnen übereinander verlaufen und bei dem jede Leiterbahn in einer senkrecht zur Leiterbahn verlaufenden Anschlußfahne (77, 79, 81, 83, 85, 87, 89, 91)endet, wobei die einzelnen Anschlußfahnen (77, 79, 81, 83, 85, 87, 89, 91)zueinander parallel angeordnet sind und zum Anschluß von an sie angrenzenden piezoelektrischen Elementen (1, 3, 5, 7, 9, 11) dienen.

5. Elektromechanischer Wandler gemäß einem der vorangehenden Ansprüche, bei dem auf der flexiblen Leiterplatte (13, 13a, 13b, 13c) elektronische Bauteile, insb. SMD-Bauteile (49), angeordnet sind.

6. Verfahren zur Herstellung eines elektromechanischen Wandlers gemäß einem der vorangehenden Ansprüche, bei dem
- die flexible Leiterplatte (13, 13a, 13b, 13c ) mit Bauteilen bestückt wird,
- die Anschlußfahnen (33, 35, 37, 39, 41, 43, 45, 47, 55, 57, 59, 61, 63, 65, 67, 69, 77, 79, 81, 83, 85, 87, 89, 91) durch Verformen der flexiblen Leiterplatte (13, 13a, 13b, 13c) parallel zueinander und übereinander angeordnet werden, wodurch die piezoelektrischen Elemente (1, 3, 5, 7, 9, 11) aufeinander gestapelt werden, und
- der Stapel verpreßt wird.

7. Verfahren nach Anspruch 6, bei dem die Bauteile piezoelektrische Elemente (1, 3, 5, 7, 9, 11) und SMD-Bauteile (49) sind, und die Bestückung automatisch erfolgt.

8. Vorrichtung zur Feststellung und/oder Überwachung eines vorbestimmten Füllstandes in einem Behälter, welche Vorrichtung umfaßt:
- ein auf der Höhe des vorbestimmten Füllstandes anzubringendes mechanisches Schwingungsgebilde, und
- einen elektromechanischen Wandler (101) gemäß einem der Ansprüche 1 bis 5,
-- der im Betrieb dazu dient das mechanische Schwingungsgebilde in Schwingungen zu versetzten und dessen von einem momentanen Füllstand abhängige Schwingungen aufzunehmen und einer weiteren Verarbeitung und/oder Auswertung zugänglich zu machen.

## Claims

1. An electromechanical transducer, which comprises
- piezoelectric elements (1, 3, 5, 7, 9,11) which are arranged in a stack and,
- between which contact electrodes (G, S, E) are arranged, by way of which the piezoelectric elements (1, 3, 5, 7, 9, 11) are electrically connected, **characterized in that**
- the contact electrodes (G, S, E) are flat terminal lugs (33, 35, 37, 39, 41, 43, 45, 47, 55, 57, 59, 61, 63, 65, 67, 69, 77, 79, 81, 83, 85, 87, 89, 91) extending out of a flexible printed circuit board (13, 13a, 13b, 13c).

2. An electromechanical transducer according to Claim 1, in which
- the flexible printed circuit board (13a) has a step-shaped portion (17),
- a flat terminal lug (33, 35, 37, 39, 41, 43, 45, 47, 49) extends out at each step (19, 21, 23, 25, 27, 29, 31), and
- the steps (19, 21, 23, 25, 27, 29, 31) have a height which is equal to the thickness of the piezoelectric elements (1, 3, 5, 7, 9, 11) bounding the respective step (19, 21, 23, 25, 27, 29, 31).

3. An electromechanical transducer according to Claim 1, in which
- the stack comprises at least two partial stacks arranged one above the other, and
- the piezoelectric elements (1, 3, 5, 7; 9, 11) of each partial stack are attached by means of terminal lugs (55, 57, 59, 61, 63, 65, 67, 69) which are arranged around a base face (71, 73) of the flexible printed circuit board (13b) associated with the partial stack and which extend out of the printed circuit board (13b).

4. An electromechanical transducer according to Claim 1, in which the flexible printed circuit board (13c) has a portion (75) in which a plurality of conductor tracks extend one above the other and in which each conductor track terminates in a terminal lug (77, 79, 81, 83, 85, 87, 89, 91) extending at a right angle to the conductor track, wherein the individual terminal lugs (77, 79, 81, 83, 85, 87, 89, 91) are arranged parallel to one another and are used for connecting piezoelectric elements (1, 3, 5, 7, 9, 11) adjacent to them.

5. An electromechanical transducer according to one of the preceding Claims, in which electronic components, in particular surface-mounted devices (49), are arranged on the flexible printed circuit board (13, 13a, 13b, 13c).

6. A method of producing an electromechanical transducer according to one of the preceding Claims, in which
- the flexible printed circuit board (13, 13a, 13b, 13c) is assembled with components,
- the terminal lugs (33, 35, 37, 39, 41, 43, 45, 47, 55, 57, 59, 61, 63, 65, 67, 69, 77, 79, 81, 83, 85, 87, 89, 91) are arranged parallel to one another and one above the other by deformation of the flexible printed circuit board (13, 13a, 13b, 13c), as a result of which the piezoelectric elements (1, 3, 5, 7, 9, 11) are stacked one above the other, and
- the stack is pressed.

7. A method according to Claim 6, in which the components are piezoelectric elements (1, 3, 5, 7, 9, 11) and SMD components (49), and the assembly takes place automatically.

8. A device for ascertaining and/or monitoring a pre-determined filling state in a container, the device comprising:
- a mechanical oscillation structure to be attached at the level of the pre-determined filling state, and
- an electromechanical transducer (101) according to one of Claims 1 to 5,
- which is used in operation to convert the mechanical oscillation structure into oscillations and to pick up its oscillations dependent upon a momentary filling state and to make them accessible for further processing and/or evaluation.

## Revendications

1. Transducteur électromécanique comprenant :
- des éléments (1, 3, 5, 7, 9, 11) piézoélectriques disposés dans une pile,
- entre lesquels éléments, on a disposé des électrodes de contact (G, S, E) grâce auxquels les éléments (1, 3, 5, 7, 9, 11) piézoélectriques sont raccordés de façon électrique, **caractérisé en ce que** les électrodes de contact (G, S, E) sont des cosses de raccordement (33, 35, 37, 39, 41, 43, 45, 47, 55, 57, 59, 61, 63, 65, 67, 69, 77, 79, 81, 83, 85, 87, 89, 91) conduites hors d'une carte de circuit imprimé (13, 13a, 13b, 13c) flexible.

2. Transducteur électromécanique conforme à la revendication 1, dans lequel
- la carte de circuit imprimé (13a) flexible présente un tronçon (17) formé en gradins,
- une cosse de raccordement (33, 35, 37, 39, 41, 43, 45, 47, 49) bidimensionnelle est conduite vers l'extérieur à chaque gradin (19, 21, 23, 25, 27, 29, 31), et
- les gradins (19, 21, 23, 25, 27, 29, 31) présentent une hauteur qui est égale à l'épaisseur des éléments (1, 3, 5, 7, 9, 11) piézoélectriques contigus à chaque gradin (19, 21, 23, 25, 27, 29, 31).

3. Transducteur électromécanique conforme à la revendication 1, dans lequel
- la pile est composée d'au moins deux piles partielles disposées l'une sur l'autre, et
- les éléments piézoélectriques (1, 3, 5, 7, 9, 11) de chaque pile partielle sont reliés au moyen de cosses de raccordement (55, 57, 59, 61, 63, 65, 67, 69) disposés autour d'une surface de base (71, 73) de la carte de circuit imprimé (13b) flexible et conduites hors de la carte de circuit imprimé , ladite surface de base étant associée à chaque pile partielle.

4. Transducteur électromécanique conforme à la revendication 1, dans lequel la carte de circuit imprimé (13c) flexible présente un tronçon (75) dans lequel plusieurs pistes conductrices s'étendent l'une au dessus de l'autre et dans lequel chaque piste conductrice se termine dans une cosse de raccordement (77, 79, 81, 83, 85, 87, 89, 91) s'étendant de façon perpendiculaire par rapport à la piste conductrice ; les différentes cosses de raccordement (77, 79, 81, 83) sont disposés de façon parallèle l'une par rapport à l'autre et servent à raccorder les éléments (1, 3, 5, 7, 9, 11) piézoélectriques contiguës audites cosses de raccordement.

5. Transducteur électromécanique conforme à une des revendications précédentes, dans lequel on a disposé sur la carte de circuit imprimé (13, 13a, 13b, 13c) flexible, des éléments électroniques, notamment des éléments (49)-SMD.

6. Procédé pour la fabrication d'un transducteur électromécanique conformément à une des revendications précédentes, dans lequel :
- la carte de circuit imprimé (13, 13a, 13b, 13c) flexible est équipée d'éléments de construction,
- les cosses de raccordement (33, 35, 37, 39, 41, 43, 45, 47, 55, 57, 59, 61, 63, 65, 67, 69, 77, 79, 81, 83, 85, 87, 89, 91) sont disposées de façon parallèle l'une par rapport à l'autre en déformant la carte de circuit imprimé (13, 13a, 13b, 13c) flexible, ce qui permet d'empiler l'un sur l'autre les éléments (1, 3, 5, 7, 9, 11) piézoélectriques, et
- la pile est comprimée.

7. Procédé selon la revendication 6, dans lequel les éléments sont des éléments (1, 3, 5, 7, 9, 11) piézoélectriques et des éléments (49), et l'équipement se déroule de façon automatique.

8. Dispositif pour déterminer et / ou surveiller un niveau de remplissage prédéterminé dans un récipient, lequel dispositif comprend :
- une entité de vibration mécanique à disposer à hauteur du niveau de remplissage prédéterminé, et
- un transducteur électro-mécanique (101) selon une des revendications 1 à 5,
- qui, pendant le fonctionnement, sert à faire vibrer l'entité mécanique et à recevoir les vibrations liées au niveau de remplissage momentané et à transmettre ces vibrations à un traitement et / ou évaluation ultérieurs.
